# FASCICULE DE BREVET EUROPEEN

(11) **EP 0 490 786 B1**
(45) Date de publication et mention de la délivrance du brevet: **13.03.1996**
(21) Numéro de dépôt: 91420429.2
(22) Date de dépôt: 03.12.1991
(51) Int. Cl.: H02H 9/04, H04M 3/18

(54) **Circuit de protection programmable et sa réalisation monolithique**
Programmierbare Schutzschaltung und deren monolitische Ausführung
Programmable protection circuit and monolithic manufacturing thereof

(30) Priorité: 07.12.1990 FR 9015639
(43) Date de publication de la demande: 17.06.1992
(73) Titulaire: SGS-THOMSON MICROELECTRONICS S.A., F-94250 Gentilly (FR)
(72) Inventeur: Pezzani, Robert, F-37210 Vouvray (FR); Bernier, Eric, F-37100 Tours (FR)
(74) Mandataire: de Beaumont, Michel

(56) Documents cités:
- FR-A- 2 096 663
- FR-A- 2 433 845
- US-A- 3 600 634

## Description

La présente invention concerne le domaine des circuits de protection contre des surtensions de ligne.

Parmi les circuits de protection à l'encontre de surtensions, on connaît, par exemple à partir du brevet américain 4 282 555, des schémas du type de celui illustré en figure 1 dans lequel trois modules de protection unidirectionnelle 1, 2 et 3 sont connectés entre un point commun C et une première ligne A, une deuxième ligne B et une terre M. Chacun des éléments de protection comprend en anti-parallèle un composant de protection unidirectionnelle P et une diode D, respectivement P1, D1 ; P2, D2 ; P3, D3. Les électrodes de même nature (anode ou cathode) des divers composants sont reliées au point C.

Les composants de protection P1, P2, P3 sont par exemple des thyristors sans gâchette qui deviennent conducteurs de leur anode vers leur cathode quand la tension à leurs bornes dépasse une valeur de seuil déterminée par fabrication.

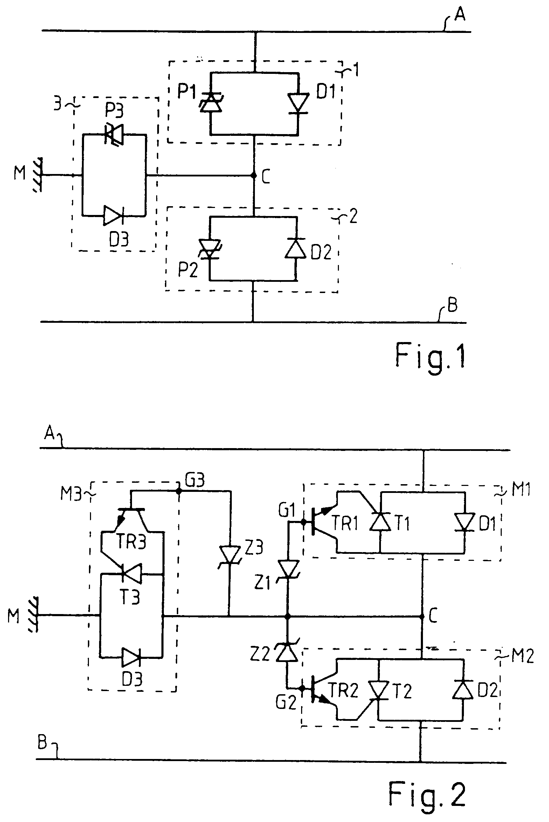

Un avantage du circuit de la figure 1 est que les trois modules représentés peuvent être intégrés sur une même puce.

Toutefois, à partir du moment où l'on choisit la solution avantageuse d'intégration monolithique des trois éléments de protection, il en résulte, pour des raisons technologiques que les tensions de claquage des trois composants de protection P1, P2, P3 seront identiques et varieront (augmenteront) avec la température du composant, un échauffement pouvant être provoqué par une surtension longue ou des surtensions brèves et répétées.

Par ailleurs, il existe des circuits ayant un thyristor coupe-circuit de surtensions dont la gâchette est attaquée par une diode zener par l'intermédiaire d'un transistor amplificateur connecté entre gâchette et anode du thyristor. Mais ces circuits sont réalisés complètement en circuit discret qui sont coûteux et encombrants et ces circuits ne sont prévus que pour la protection d'une phase, tels que décrits dans le document FR-A-2 096 663.

Ainsi, un objet de la présente invention est de prévoir un circuit de protection qui s'affranchisse des inconvénients des réalisations complètement intégrées, c'est-à-dire dans lequel d'une part la tension de protection de chacun des éléments soit réglable indépendamment de celle des autres éléments et d'autre part cette tension de protection soit indépendante de la température et qui ne présente pas l'inconvénient des coûts élevés des circuits discrets.

Pour atteindre ces objets, la présente invention prévoit un circuit de protection programmable pour une ligne comprenant trois modules identiques reliés entre un point commun et la première ligne, la deuxième ligne et une terre, ces trois modules étant réalisés dans un même circuit intégré monolithique, chaque module comprenant l'association en antiparallèle d'un thyristor et d'une diode, caractérisé en ce que un transistor bipolaire est connecté entre gâchette et anode du thyristor de chaque module, les anodes des thyristors étant reliées au point commun et la borne de base du transistor, de chaque module constituant une borne de programmation et étant connectée à un dispositif externe au circuit intégré définissant un seuil de tension.

Selon un mode de réalisation de la présente invention, le dispositif définissant un seuil de tension est une diode zener connectée entre chaque borne de base et le point commun.

La présente invention prévoit aussi un composant monolithique groupant trois modules de protection comprenant chacun un thyristor et une diode en antiparallèle, un transistor étant connecté entre la gâchette et l'anode de chaque thyristor, les anodes des thyristors étant reliées à une borne commune correspondant à la face arrière du composant monolithique, ce composant étant constitué à partir d'un substrat de type N. Chaque thyristor comprend successivement de sa cathode vers son anode une région de cathode de type N, un premier caisson de type P, le substrat, et une région de type P en contact avec la métallisation de face arrière. Chaque diode est constituée verticalement du premier caisson, du substrat et d'une région de type N en contact avec la face arrière. Chaque transistor est constitué d'un deuxième caisson de type P dans lequel est formé une région d'émetteur de type N, le substrat et une région de type N de face arrière constituant le collecteur. Une première métallisation est solidaire de la base du transistor et correspond à l'électrode de commande, une deuxième métallisation relie l'émetteur du transistor à la région de gâchette d'anode du thyristor, et une troisième métallisation recouvre la région de cathode du thyristor et le premier caisson adjacent et correspond à l'anode de la diode.

Ces objets, caractéristiques et avantages ainsi que d'autres de la présente invention seront exposés plus en détail dans la description suivante de modes de réalisation particuliers faite en relation avec les figures jointes parmi lesquelles :
la figure 1, décrite précédemment, est destiné à illustrer l'état de la technique ;
la figure 2 représente un circuit de protection programmable selon la présente invention ;
la figure 3 représente un mode d'intégration du circuit selon la présente invention ; et
les figures 4 et 5 illustrent divers montages du circuit monolithique selon la présente invention.

Comme le représente la figure 2, un circuit selon la présente invention comprend trois modules M1, M2 et M3 dont chacun est constitué de l'association en antiparallèle d'un thyristor T et d'une diode D. Chaque module comprend aussi un transistor NPN TR dont l'émetteur est connecté à la borne de gâchette du thyristor et dont le collecteur est relié à l'anode du thyristor. La base du transistor correspond à la borne de commande G du module. Dans la figure, les composants du module M1 sont affectés de l'indice 1, les composants du module M2 de l'indice 2 et les composants du module M3 de l'indice 3.

On peut considérer que, dans chacun des modules, l'ensemble d'un thyristor et d'un transistor constitue un thyristor du type à amplification de gâchette. Un tel thyristor nécessite seulement un faible courant de commande pour sa mise en conduction tout en conservant de bonnes caractéristiques de tenue en tension et de courant de maintien.

Du fait qu'un faible courant de commande est suffisant pour déclencher chacun des thyristors, les bornes de commande G de chacun des modules peuvent être connectées à l'anode d'une diode zener dont l'autre borne est connectée au point commun C. Puisque le courant est faible, les diodes zener, qui sont externes au circuit incorporant les modules, n'auront pas tendance à s'échauffer et des tensions de protection bien définies pourront être fixées pour chacun des modules M1, M2, M3. Les modules M1 et M2 ayant des rôles relativement symétriques, on pourra choisir une même tension de claquage pour les diodes zener Z1 et Z2 et éventuellement une tension de claquage différente pour la diode zener Z3. Il sera toutefois possible, dans des cas particuliers, de choisir des tensions de claquage différentes pour les diodes zener Z1 et Z2, ceci étant fonction de l'application envisagée.

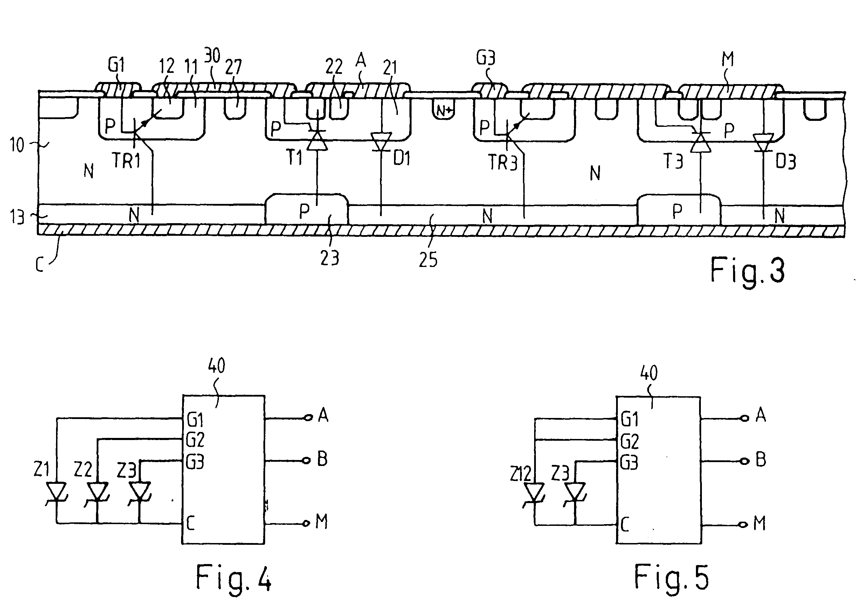

La figure 3 représente un mode d'association monolithique des modules. Plus précisément, sur la figure on a illustré pour des raisons d'encombrement l'association monolithique des seuls modules M1 et M3. Il sera toutefois clair que le module M2, qui est identique aux modules M1 et M3, est également formé sur la même puce. La figure 3 est une représentation en coupe extrêmement schématique mais qui suffira à l'homme de l'art du domaine des composants semiconducteurs, qui connaît les épaisseurs de couche classiquement obtenues par diffusion, et les dimensions latérales à donner aux divers composants en fonction notamment des puissances que l'on veut y faire passer. L'homme de l'art connaît également les niveaux de dopage utiles au fonctionnement de chacun des composants et les compromis à faire pour obtenir sur une même puce par un minimum d'étapes de diffusion des niveaux de dopage compatibles pour divers composants.

La partie gauche de la figure 3 illustre le module M1 et la partie droite le module M3. On décrira seulement le module M1, les autres modules étant identiques.

La structure monolithique est formée à partir d'un substrat de silicium de type N faiblement dopé 10. La face arrière de ce substrat est recouverte d'une métallisation C correspondant au point commun C de la figure 2. Les composants TR1, T1, D1 sont de structure verticale.

La base du transistor TR1 correspond à un caisson P 11 situé du côté de la face avant ou supérieure du substrat et dans lequel est formée une région d'émetteur 12 de type N. Le collecteur du transistor TR1 correspond au substrat 10 et à une région surdopée de type N 13 du côté de la face arrière du substrat.

La région de gâchette de cathode du thyristor T1 correspond à un caisson P 21 dans lequel est formée une région N 22, généralement munie de courts-circuits d'émetteur. Ainsi, ce thyristor comprend depuis sa cathode vers son anode la couche 22, le caisson 21, le substrat 10 et une couche plus dopée 23 de type P en contact avec la métallisation C.

La diode D1 est constituée par le caisson P 21, le substrat 10 et une région de type N surdopée 25.

On notera que dans cette structure, les différents modules et les différents composants d'un module ne sont pas isoles uns des autres par des régions de diffusion profondes. On prévoiera toutefois de préférence des régions d'arrêt de canal de type N⁺ 27 entre les divers caissons P.

En ce qui concerne les métallisations de la face avant, elles sont représentées par des régions hachurées en contact avec des régions semiconductrices ou des portions de couche isolante non référencées, généralement en oxyde de silicium. Une métallisation G1 en contact avec le caisson P 11 correspond à la borne de commande G1 du module M1. Une métallisation de liaison 30 relie l'émetteur 12 du transistor TR1 à la région de gâchette de cathode 21 du thyristor T1. Enfin, une métallisation recouvrant la couche de cathode 22 et la surface apparente du caisson 21 est destinée à être reliée à la ligne A et correspond à la cathode du transistor T1 et à l'anode de la diode D1.

Les figures 4 et 5 représentent la structure monolithique de la figure 3 sous forme d'un bloc 40 comprenant des bornes G1, G2, G3 et C destinées à être reliées aux diverses diodes zener et des bornes A, B et M destinées à être reliées à la ligne A, à la ligne B et à la terre. Le schéma de la figure 4 est conforme à celui de la figure 2. Dans le schéma de la figure 5, on a voulu montrer qu'une diode unique Z12 pouvait être employée pour remplacer les diodes Z1 et Z2 dans le cas où l'on ne veut pas programmer différemment les tensions de protection des modules M1 et M2. On pourrait même prévoir une diode unique reliée aux trois bornes G1, G2, G3.

La présente invention est susceptible de diverses variantes et modifications qui apparaîtront à l'homme de l'art. Par exemple, les transistors d'amplification de gâchette TR pourraient être remplacés par des thyristors d'amplification de gâchette. Ceci eut être réalisé simplement dans l'exemple de structure monolithique de la figure 3 en remplaçant la couche 13 de type N par une couche de type P.

Par ailleurs, on a décrit ci-dessus un mode de réalisation de la présente invention dans lequel les tensions de retournement sont déterminées par des diodes zener. On pourrait aussi prévoir, pour des tensions de programmation de 0 à 150V, d'appliquer une tension de batterie externe directement sur les bornes G1, G2 et G3. La tension programmée de retournement serait alors définie par la tenue en tension de la jonction émetteur-base des transistors TR1, TR2, TR3.

## Revendications

1. Circuit de protection programmable pour une ligne comprenant trois modules identiques reliés entre un point commun (C) et la première ligne (A), la deuxième ligne (B) et une terre (M), ces trois modules étant réalisés dans un même circuit intégré monolithique, chaque module comprenant l'association en antiparallèle d'un thyristor (T) et d'une diode (D), caractérisé en ce que un transistor bipolaire (TR) est connecté entre gâchette et anode du thyristor de chaque module, les anodes des thyristors étant reliées au point commun et la borne de base du transistor de chaque module constituant une borne de programmation et étant connectée à un dispositif externe au circuit intégré définissant un seuil de tension.

2. Circuit de protection programmable selon la revendication 1, caractérisé en ce que chacun des dispositifs définissant un seuil de tension est une diode zener (Z1, Z2, Z3) connectée entre chaque borne de base et ledit point commun.

3. Composant monolithique groupant trois modules de protection comprenant chacun un thyristor (T) et une diode (D) en antiparallèle, un transistor (TR) étant connecté entre la gâchette et l'anode de chaque thyristor, les anodes des thyristors étant reliées à une borne commune (C) correspondant à la face arrière du composant monolithique, ce composant étant constitué à partir d'un substrat (10) de type N,
chaque thyristor comprenant successivement de sa cathode vers son anode une région de cathode (22) de type N, un premier caisson (21) de type P, le substrat (10), et une région (23) de type P en contact avec la métallisation de face arrière (C),
chaque diode étant constituée verticalement dudit premier caisson (21), du substrat (10) et d'une région (25) de type N en contact avec la face arrière (C), et le composant étant caractérisé en ce que :
chaque transistor (TR) est constitué d'un deuxième caisson (11) de type P dans lequel est formé une région d'émetteur (12), de type N le substrat (10) et une région (13) de type N de face arrière constituant le collecteur,
une première métallisation (G1) étant solidaire de la base du transistor et correspondant à l'électrode de commande, une deuxième métallisation (30) reliant l'émetteur du transistor à la région de gâchette d'anode du thyristor, et une troisième métallisation (A) recouvrant la région de cathode du thyristor et le premier caisson (21) adjcacent correspondant à l'anode de la diode.

## Patentansprüche

1. Programmierbare Schutzschaltung für eine Leitung, welche drei identische Module aufweist, die zwischen einem gemeinsamen Punkt (C) und der ersten Leitung (A), der zweiten Leitung (B) und Masse (M) angeschlossen sind, wobei diese drei Module in ein und derselben monolithischen integrierten Schaltung realisiert sind und jedes Modul eine nicht parallele Anordnung aus einem Thyristor (T) und einer Diode (D) aufweist, dadurch gekennzeichnet, daß ein bipolarer Transistor (TR) zwischen dem Gate und der Anode des Thyristors jedes Modul angeschlossen ist, die Anoden des Thyristors mit dem gemeinsamen Punkt verbunden sind und der Basisanschluß des Transistors jedes Moduls einen Programmieranschluß bildet und mit einer zu der integrierten Schaltung externen Einrichtung verbunden ist, welche einen Spannungsschwellwert definiert.

2. Programmierbare Schutzschaltung nach Anspruch 1, dadurch gekennzeichnet, daß jede der Einrichtungen, welche einen Spannungsschwellwert definieren, eine Zenerdiode (Z1, Z2, Z3) ist, welche zwischen jedem Basisanschluß und dem gemeinsamen Punkt angeschlossen sind.

3. Monolithisches Bauteil, welches drei Schutzmodule zusammenfaßt, die jeweils einen Thyristor (T) und eine Diode (D) in einer nicht parallelen Anordnung aufweisen, wobei ein Transistor (TR) zwischen dem Gate und der Anode jedes Thyristors angeschlossen sind, die Anoden der Thyristoren mit einem gemeinsamen Anschluß (C) verbunden sind, welcher der rückwärtigen Oberfläche des monolithischen Bauteils entspricht, und das Bauteil aus einem Substrat (10) des N-Typs hergestellt ist, wobei
jeder Transistor der Reihe nach, von seiner Kathode zu seiner Anode, einen Kathodenbereich (22) des N-Typs, eine erste Senke (21) des P-Typs, das Substrat (10) und einen Bereich (23) des P-Typs in Kontakt mit der Metallisierung (C) der rückwärtigen Oberfläche aufweist, und
jede Diode, in vertikaler Richtung, die erste Senke (21), das Substrat (10) und einen Bereich (25) des N-Typs in Kontakt mit der rückwärtigen Oberfläche (C) aufweist, und das Bauteil dadurch gekennzeichnet ist, daß
jeder Transistor (TR) aus einer zweiten Senke (11) des P-Typs, in welcher ein Emitterbereich (12) des N-Typs ausgebildet ist, dem Substrat (10) und einem Bereich (13) des N-Typs der rückwärtigen Oberfläche, welcher den Kollektor bildet, aufgebaut ist, und
eine erste Metallisierung (G1) an der Basis des Transistors befestigt ist und der Steuerelektrode entspricht, eine zweite Metallisierung (30) den Emitter des Transistors mit dem Gatebereich der Anode des Thyristors verbindet, und eine dritte Metallisierung (A) den Kathodenbereich des Thyristors und die erste angrenzende Senke (21) bedeckt, welche der Anode der Diode entspricht.

## Claims

1. A programmable protection circuit for a line comprising three identical units connected between a common point (C) and the first conductor (A), the second conductor (B) and ground (M), said three units being achieved in a same monolithic integrated circuit, each unit comprising a non-parallel association of a thyristor (T) and a diode (D), characterized in that a bipolar transistor (TR) is connected between the gate and anode of the thyristor of each unit, the anodes of the thyristors being connected to the common point and the base terminal of the transistor of each unit constituting a programmation terminal and being connected to a device external to said integrated circuit defining a voltage threshold.

2. A programmable protection circuit according to claim 1, wherein each device defining a voltage threshold is a zener diode (Z1, Z2, Z3) connected between each base terminal and said common point.

3. A monolithic component associating three protection units each comprising a thyristor (T) and a diode (D) in a non-parallel arrangement, a transistor (TR) being connected between the gate and anode of each thyristor, the anodes of the thyristors being connected to a common terminal (C) corresponding to the rear surface of the monolithic component, said component being made from an N-type substrate (10),
each thyristor successively comprising, from its cathode to its anode, an N-type cathode region (22), a first P-type well (21), the substrate (10), and a P-type region (23) in contact with the metallization (C) of the rear surface,
each diode comprising, vertically, said first well (21), said substrate (10) and an N-type region (25) in contact with the rear surface (C), and
this component being characterized in that:
each transistor (TR) is constituted by a second P-type well (11) wherein is formed an N-type emitter region (12), said substrate (10) and an N-type rear surface region (13) constituting the collector,
a first metallization (G1) being fixed to the transistor base and corresponding to the control electrode, a second metallization (30) connecting the transistor emitter to the anode gate region of the thyristor, and a third metallization (A) coating the cathode region of said thyristor and the first adjacent well (21) corresponding to the diode anode.
